# EUROPÄISCHE PATENTSCHRIFT

(11) **EP 2 244 230 B1**
(45) Veröffentlichungstag und Bekanntmachung des Hinweises auf die Patenterteilung: **19.06.2013**
(21) Anmeldenummer: 09450082.4
(22) Anmeldetag: 20.04.2009
(51) Int. Cl.: G07B 15/00

(54) **Komponenten und Verfahren zum Messen der Funktionsfähigkeit eines Strassenmautsystems**
Components and method for measuring the functionality of a road toll system
Composants et procédé de mesure de la fonctionnalité d'un système de péage routier

(43) Veröffentlichungstag der Anmeldung: 27.10.2010
(73) Patentinhaber: Kapsch TrafficCom AG, 1120 Wien (AT)
(72) Erfinder: Nagy, Oliver, 1190 Wien (AT)
(74) Vertreter: Weiser, Andreas

(56) Entgegenhaltungen:
- EP-A- 1 130 406
- EP-A- 1 457 928
- WO-A-01/11571
- WO-A-03/038763
- WO-A-2009/010919
- JP-A- 11 304 900

## Beschreibung

Die vorliegende Erfindung betrifft ein Fahrzeuggerät für Straßenmautsysteme, welches einen Satellitennavigationsempfänger zur Positionsbestimmung und einen daran angeschlossenen, von diesem Positionsdaten erhaltenden Mobilfunk-Sendeempfänger zum Verarbeiten und Senden derselben als Positionsmeldungen an eine Zentrale aufweist. Die Erfindung betrifft ferner ein Verfahren zum Messen der Funktionsfähigkeit eines solchen Straßenmautsystems.

Zum Messen der Funktionsfähigkeit derartiger Straßenmautsysteme werden derzeit Testfahrzeuge eingesetzt, die vorgegebene Strecken stichprobenartig abfahren, wobei die im System erzeugten Mauttransaktionen anschließend manuell ausgewertet werden. Dies bedeutet einen hohen personellen und organisatorischen Aufwand, insbesondere wenn die Funktionsfähigkeit kontinuierlich überwacht oder periodisch die Leistung eines Straßenmautsystems ermittelt werden soll.

Aus der EP 1 333 404 A1 ist eine stationäre Überwachungseinrichtung für von Fahrzeugen mitgeführte Fahrzeuggeräte eines Straßenmautsystems bekannt, welche "Pseudo"- bzw. "Dummy"-Positionsdaten in ein Fahrzeuggerät einspeist, wenn dieses davor steht, um die daraufhin erzeugten Verrechnungstransaktionen zu überprüfen. Diese Lösung erfordert straßenseitige Überwachungsgeräte vor Ort und ist daher nur kleinräumig und kostenaufwendig umsetzbar.

Die Erfindung setzt sich zum Ziel, Komponenten und Verfahren für ein Straßenmautsystem zu schaffen, welche die Nachteile des bekannten Standes der Technik überwinden und eine einfache, rasche und automatisierbare Überprüfung der Funktionsfähigkeit eines Straßenmautsystems gestatten.

Dieses Ziel wird in einem ersten Aspekt mit einem Fahrzeuggerät der einleitend genannten Art erreicht, das sich erfindungsgemäß durch einen sich im Fahrzeuggerät befindenden, wahlweise anstelle des Satellitennavigationsempfängers an den Sendeempfänger anschaltbaren Testsignalgenerator zur Einspeisung von Test-Positionsdaten in den Sendeempfänger auszeichnet.

Die Erfindung ermöglicht erstmals eine einfache und automatisierbare Überprüfung eines Straßenmautsystems im laufenden Betrieb, indem am Ursprung der Mauttransaktionen, in den Fahrzeuggeräten selbst und vor jedweder Weiterverarbeitung, Positionsdaten zu Testzwecken eingespeist werden. Auf diese Weise kann sowohl die Funktionsfähigkeit des Positionsdatenverarbeitungs- und -sendeteils eines Fahrzeuggeräts als auch des gesamten weiteren Übertragungs- und Auswertungswegs bis hin zu den Mauttransaktionen in der Zentrale überprüft werden, weil die Test-Positionsdaten vorbekannt sind und somit die sich daraus ergebenden Mauttransaktionen einfach und automatisiert überprüft werden können.

Gemäß der Erfindung ist der Testsignalgenerator auf eine vom Sendeempfänger dekodierte Anforderung der Zentrale im laufenden Betrieb zu zufälligen Zeitpunkten oder vorgegebenen Tageszeiten anschaltbar. Dadurch können einzelne oder Gruppen von Fahrzeuggeräten von der Zentrale über das Mobilfunknetz angerufen und in den Testbetrieb versetzt werden, sodaß jederzeit Stichprobenüberprüfungen möglich sind.

Gemäß einer alternativen oder zusätzlichen Ausführungsform erfolgt die Anschaltung des Testsignalgenerators durch einen Zeitgeber zeitgesteuert. Dadurch können z.B. periodische Funktionsprüfungen vorgenommen werden, und die Zentrale kann Test-Mauttransaktionen auch alleine aus dem Zeitpunkt ihres Auftretens von normalen Mauttransaktionen unterscheiden.

Alternativ oder zusätzlich kann die Anschaltung des Testsignalgenerators auch durch einen Zufallsgenerator gesteuert sein und zu zufälligen Zeitpunkten erfolgen. Eine weitere alternative oder zusätzliche Möglichkeit ist es, daß die Anschaltung des Testsignalgenerators durch ein Watchdog-Modul gesteuert ist, d.h. ein Modul, welches die interne Funktionsfähigkeit des Fahrzeuggeräts überwacht und z.B. bei statistischen Unregelmäßigkeiten, beispielsweise überdurchschnittlich langen Zeitabständen zwischen den gesendeten Positionsmeldungen, den Testsignalgenerator anschaltet.

Im einfachsten Fall kann der Testsignalgenerator die Test-Positionsdaten in einem Speicher vorgegeben enthalten. Alternativ empfängt der Testsignalgenerator die Test-Positionsdaten über den Sendeempfänger von der Zentrale, sodaß immer wieder neue Test-Positionsdaten verwendet werden können.

Besonders günstig ist es, wenn der Sendeempfänger die auf Test-Positionsdaten beruhenden Positionsmeldungen mit einer speziellen Kennung versieht, sodaß die Zentrale Test-Mauttransaktionen anhand einer solchen Kennung detektieren kann und Systemtests zu jedem beliebigen Zeitpunkt durchgeführt werden können.

In einem zweiten Aspekt schafft die Erfindung ein Verfahren zum Messen der Funktionsfähigkeit eines Straßenmautsystems, das eine Zentrale, ein Mobilfunknetz und eine Vielzahl von Fahrzeuggeräten der vorgestellten Art umfaßt und das sich auszeichnet durch die Schritte

Einspeisen von Test-Positionsdaten in die Fahrzeuggeräte,
Empfangen von auf diesen Test-Positionsdaten beruhenden Positionsmeldungen von den Fahrzeuggeräten über das Mobilfunknetz in der Zentrale, und
Vergleichen der empfangenen Positionsmeldungen mit in der Zentrale aus den Test-Positionsdaten emulierten Positionsmeldungen.

Bevorzugt erfolgt das Einspeisen durch Senden der Test-Positionsdaten von der Zentrale über das Mobilfunknetz an die Fahrzeuggeräte.

Im Falle von Fahrzeuggeräten, die spezielle Kennungen für Test-Positionsmeldungen verwenden, detektiert die Zentrale bevorzugt die zu vergleichenden Positionsmeldungen anhand ihrer Kennung.

In weiterer Folge kann die Zentrale die Vergleichsergebnisse einer Vielzahl von Fahrzeuggeräten statistisch auswerten, um ein Leistungsmaß des Straßenmautsystems zu erstellen, und/oder eine Fehlermeldung signalisieren, wenn auf die Test-Positionsdaten keine oder fehlerhafte Positionsmeldungen empfangen werden.

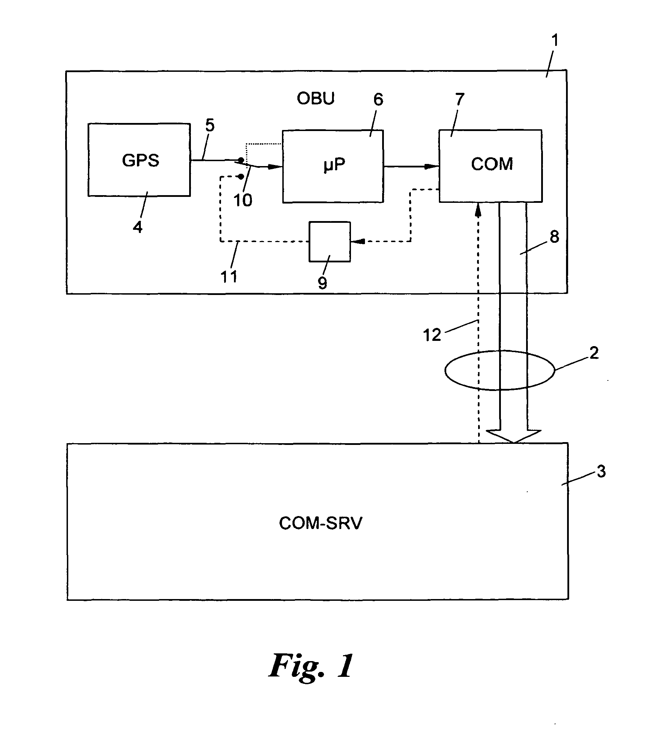

Weitere Merkmale und Vorteile der Erfindung ergeben sich aus der nachfolgenden Beschreibung eines bevorzugten Ausführungsbeispieles, welches auf die begleitende Zeichnung bezug nimmt, deren einzige Fig. 1 ein Blockschaltbild eines Fahrzeugsgeräts der Erfindung in Verbindung mit einem Straßenmautsystem zeigt.

In Fig. 1 ist - stellvertretend für eine Vielzahl von Fahrzeuggeräten - ein Fahrzeuggerät (onboard unit, OBU) 1 dargestellt, welches über ein Mobilfunknetz 2 mit einer Zentrale 3 in Verbindung steht. Weitere Komponenten, z.B. ein Proxy-Rechner, können optional zwischen Fahrzeuggerät 1 und Zentrale 3 zwischengeschaltet sein.

Das Fahrzeuggerät 1 enthält einen Satellitennavigationsempfänger 4 zur Bestimmung seiner eigenen Position innerhalb eines (nicht dargestellten) globalen Satellitennavigationssystems (global navigation satellite system, GNSS), z.B. des GPS- oder GALILEO-Netzes. Die am Ausgang des Satellitennavigationsempfängers 4 erhaltenen Positionsdaten 5, z.B. eine Abfolge von "position fixes", werden einem Mobilfunk-Sendeempfänger aus einer Mikroprozessorsteuerung 6 und einem Kommunikationsmodul 7 zugeführt.

Der Sendeempfänger 6, 7 erzeugt aus den Positionsdaten 5 für die Zentrale 3 aufbereitete Positionsmeldungen 8 zur Übermittlung über das Mobilfunknetz 2. Die Positionsmeldungen 8 können beispielsweise eine paketierte Version der Positionsdaten 5 sein ("thin client"-OBU), oder das Ergebnis einer Kartenzuordnung ("map maching") der Positionsdaten 5 zu bestimmten geographischen Gebieten wie mautpflichtigen Straßensegmenten ("thick client"-OBU), wie dem Fachmann bekannt.

Die Zentrale 3 erstellt aus den empfangenen Positionsmeldungen 8 - soferne diese nicht bereits "fertige" Mauttransaktionen sind - Mauttransaktionen zur Vergebührung der Ortsnutzungen des Fahrzeuggeräts 1.

Zur Überprüfung der Funktionsfähigkeit des Fahrzeuggeräts 1 und in der Folge auch des gesamten Straßenmautsystems 1 - 3 ist das Fahrzeuggerät 1 mit einem Testsignalgenerator 9 ausgestattet, welcher über einen - nur symbolisch zu verstehenden - Umschalter 10, z.B. von der Mikroprozessorsteuerung 6 gesteuert, anstelle des Satellitennavigationsempfängers 4 an den Sendeempfänger 6, 7 anschaltbar ist. In der strichlierten Stellung des Schalters 10 werden anstelle der Positionsdaten 5 Test-Positionsdaten 11 aus dem Testsignalgenerator 9 in den Sendeempfänger 6, 7 eingespeist, um dementsprechende Test-Positionsmeldungen 8 an die Zentrale 3 abzusetzen und in dieser Test-Mauttransaktionen zu erzeugen.

Die Test-Positionsdaten 11 entsprechen in ihrem Aufbau und Format den Positionsdaten 5 des Satellitennavigationsempfängers 4, sodaß die gesamte Verarbeitungsfunktionalität der Übertragungskette aus Sendeempfänger 6, 7, Mobilfunknetz 2 und Zentrale 3 bis hin zu den Mauttransaktionen überprüft werden kann, ohne daß dazu Änderungen im laufenden Betrieb erforderlich sind.

Die Test-Positionsdaten 11 können in einem Speicher des Testsignalgenerators 9 vorgegeben sein. Alternativ können sie über einen eigenen Signalpfad 12 von der Zentrale 3 in den Testsignalgenerator 9 zur sofortigen oder späteren Verwendung eingespeist werden; im einfachsten Fall ist daher der Testsignalgenerator 9 "transparent" und schleift von der Zentrale 3 empfangene Test-Positionsdaten 11 zum Sendeempfänger 6, 7 durch. Der Signalpfad 12 verwendet bevorzugt ebenfalls das Mobilfunknetz 2, sodaß die Test-Positionsdaten 11 beispielsweise im Zuge eines Datenanrufs von der Zentrale 3 zum Fahrzeuggerät 1 übermittelt werden können.

Das Anschalten des Testsignalgenerators 9 an den Sendeempfänger 6, 7 kann beispielsweise von einem Zeitgeber zeitgesteuert zu vorgegebenen Tageszeiten oder einem vorgegebenen Datum erfolgen, sodaß die Zentrale 3 in der Lage ist, die zu diesem Zeitpunkt oder Datum empfangenen Positionsmeldungen 8 als auf Test-Positionsdaten 11 zurückgehend zu erkennen. Alternativ oder zusätzlich kann der Testsignalgenerator 9 die Test-Positionsdaten 11, oder der Sendeempfänger 6, 7 die Test-Positionsmeldungen 8, mit einer speziellen Kennung versehen, welche von der Zentrale 3 detektierbar ist.

Das Anschalten des Testsignalgenerators 9 kann darüber hinaus auch z.B. von einem Zufallsgenerator gesteuert zu zufälligen Zeitpunkten erfolgen, und/oder von einem Watchdog-Modul des Fahrzeuggeräts veranlaßt werden, welches z.B. bei statistischen Unregelmäßigkeiten des Fahrzeuggeräts 1, beispielsweise einem überdurchschnittlich langen Ausbleiben einer Positionsmeldung, den Testsignalgenerator 9 zum Einsatz bringt.

Der Testsignalgenerator 9, der Umschalter 10, der Zeitgeber, der Zufallsgenerator und/oder das Watchdog-Modul können beispielsweise durch entsprechende von der Mikroprozessorsteuerung 6 ausgeführte Programm-Module realisiert sein.

Optional kann das Anschalten des Testsignalgenerators 9 an den Sendeempfänger 6, 7 auch von der Zentrale 3 aus veranlaßt werden, z.B. mittels einer über den Signalpfad 12 übertragenen Anforderung. Eine solche Anforderung kann unabhängig von oder gemeinsam mit der Übermittlung von Test-Positionsdaten 11 von der Zentrale 3 aus erfolgen.

In der Zentrale 3 werden die so erhaltenen Test-Positionsmeldungen 8 ("Ist"-Test-Positionsmeldungen) mit für die vorgegebenen Test-Positionsdaten 12 berechneten (emulierten) "Soll"-Test-Positionsmeldungen verglichen; im Gleichheitsfall ergibt sich die Funktionsfähigkeit der Verarbeitungs- und Übertragungskette 1 - 3. Die Zentrale 3 kann aus einer statistischen Auswertung der Vergleichsergebnisse einer Vielzahl von Fahrzeuggeräten 1 auch ein statistisches Leistungsmaß (performance index) des gesamten Straßenmautsystems erstellen. Dazu können beispielsweise hundert oder tausend über ein geographisches Gebiet verteilte Fahrzeuggeräte 1 in den Testbetrieb versetzt und deren Test-Positionsmeldungen 8 statistisch ausgewertet werden.

Es versteht sich, daß die dargestellten und erörterten Komponenten des Fahrzeuggeräts 1 als Hardware-, als Software-, aber auch als eine Mischung von Hardware- und Softwarekomponenten realisiert werden können.

Die Erfindung ist nicht auf die dargestellten Ausführungsformen beschränkt, sondern umfaßt alle Varianten und Modifikationen, die in den Rahmen der angeschlossenen Ansprüche fallen.

## Patentansprüche

1. Fahrzeuggerät (1) für Straßenmautsysteme, welches einen Satellitennavigationsempfänger (4) zur Positionsbestimmung und einen daran angeschlossenen, von diesem Positionsdaten (5) erhaltenden Mobilfunk-Sendeempfänger (6, 7) zum Verarbeiten und Senden derselben als Positionsmeldungen (8) an eine Zentrale (3) aufweist, **gekennzeichnet durch** einen sich im Fahrzeuggerät (1) befindenden, wahlweise anstelle des Satellitennavigationsempfängers (4) an den Sendeempfänger (6, 7) anschaltbaren Testsignalgenerator (9) zur Einspeisung von Test-Positionsdaten (11) in den Sendeempfänger (6, 7), wobei der Testsignalgenerator (9) auf eine vom Sendeempfänger (6, 7) dekodierte Anforderung der Zentrale (3) im laufenden Betrieb zu zufälligen Zeitpunkten oder vorgegebenen Tageszeiten anschaltbar ist und/oder die Anschaltung des Testsignalgenerators (9) **durch** einen Zeitgeber (6) und/oder einen Zufallsgenerator (6) und/oder ein Watchdog-Modul (6) gesteuert ist.

2. Fahrzeuggerät nach Anspruch 1, **dadurch gekennzeichnet, dass** der Testsignalgenerator (9) die Test-Positionsdaten (11) in einem Speicher vorgegeben enthält.

3. Fahrzeuggerät nach Anspruch 1 oder 2, **dadurch gekennzeichnet, dass** der Sendeempfänger (6, 7) die auf Test-Positionsdaten (11) beruhenden Positionsmeldungen (8) mit einer speziellen Kennung versieht.

4. Verfahren zum Messen der Funktionsfähigkeit eines Straßenmautsystems, das eine Zentrale (3), ein Mobilfunknetz (2) und eine Vielzahl von Fahrzeuggeräten (1) nach einem der Ansprüche 1 bis 3 umfasst, mit den Schritten
Einspeisen von Test-Positionsdaten (11) in die Fahrzeuggeräte (1) mittels eines sich im Fahrzeuggerät (1) befindenden Testsignalgenerators (9),
Empfangen von auf diesen Test-Positionsdaten (11) beruhenden Positionsmeldungen (8) von den Fahrzeuggeräten (1) über das Mobilfunknetz (2) in der Zentrale (3), und
Vergleichen der empfangenen Positionsmeldungen (8) mit in der Zentrale (3) aus den Test-Positionsdaten (11) emulierten Positionsmeldungen,
wobei der Testsignalgenerator (9) auf eine vom Sendeempfänger (6, 7) dekodierte Anforderung der Zentrale (3) im laufenden Betrieb zu zufälligen Zeitpunkten oder vorgegebenen Tageszeiten angeschaltet wird und/oder die Anschaltung des Testsignalgenerators (9) durch einen Zeitgeber (6) und/oder einen Zufallsgenerator (6) und/oder ein Watchdog-Modul (6) gesteuert wird.

5. Verfahren nach Anspruch 4 in Verbindung mit Fahrzeuggeräten nach Anspruch 3, **dadurch gekennzeichnet, dass** die Zentrale (3) die zu vergleichenden Positionsmeldungen (8) anhand ihrer Kennung detektiert.

6. Verfahren nach Anspruch 4 oder 5, **dadurch gekennzeichnet, dass** die Zentrale (3) die Vergleichsergebnisse der Vielzahl von Fahrzeuggeräten (1) statistisch auswertet, um ein Leistungsmaß des Straßenmautsystems (1 - 3) zu erstellen.

7. Verfahren nach einem der Ansprüche 4 bis 6, **dadurch gekennzeichnet, dass** die Zentrale (3) eine Fehlermeldung signalisiert, wenn auf die Test-Positionsdaten (11) keine oder fehlerhafte Positionsmeldungen (8) empfangen werden.

## Claims

1. A vehicle device (1) for road toll systems, comprising a satellite navigation receiver (4) for position determination and a mobile radio transceiver (6, 7), which is connected thereto and receives position data (5) therefrom, for processing and transmitting this data as position messages (8) to a control centre (3), **characterized by** a test signal generator (9), which is present in the vehicle device (1) and can be selectively connected to the transceiver (6, 7) in place of the satellite navigation receiver (4), for feeding test position data (11) to the transceiver (6, 7), wherein, during ongoing operation at random times or predetermined times of day, the test signal generator (9) can be connected in response to a request from the control centre (3), which is decoded by the transceiver (6, 7), and/or the connection of the test signal generator (9) is controlled by a timer (6) and/or a random generator (6) and/or a watchdog module (6).

2. The vehicle device according to claim 1, **characterized in that** the test signal generator (9) contains the test position data (11) predetermined in a memory.

3. The vehicle device according to claim 1 or 2, **characterized in that** the transceiver (6, 7) provides the position messages (8) that are based on test position data (11) with a particular identifier.

4. A method for measuring the functional capability of a road toll system comprising a control centre (3), a mobile communication network (2), and a plurality of vehicle devices (1) according to any one of claims 1 to 3, comprising the following steps:
feeding test position data (11) to the vehicle devices (1) by way of a test signal generator (9) that is present in the vehicle device (1);
receiving position messages (8) that are based on this test position data (11) from the vehicle devices (1) via the mobile communication network (2) in the control centre (3); and
comparing the received position messages (8) to the position messages emulated from the test position data (11) in the control centre (3),
wherein, during ongoing operation at random times or predetermined times of day, the test signal generator (9) is connected in response to a request from the control centre (3), which is decoded by the transceiver (6, 7), and/or the connection of the test signal generator (9) is controlled by a timer (6) and/or a random generator (6) and/or a watchdog module (6).

5. The method according to claim 4 in conjunction with vehicle devices according to claim 3, **characterized in that** the control centre (3) detects the position messages (8) that are to be compared based on the identifiers thereof.

6. The method according to claim 4 or 5, **characterized in that** the control centre (3) statistically evaluates the comparison results of the plurality of vehicle devices (1) so as to create a performance index of the road toll system (1 - 3).

7. The method according to any one of claims 4 to 6, **characterized in that** the control centre (3) signals an error message if no or erroneous positions messages (8) are received in response to the test position data (11).

## Revendications

1. Appareil embarqué (1) dévolu à des systèmes de péage routier, comprenant un récepteur (4) de navigation par satellite assigné à la détermination de positions, et un émetteur-récepteur radio mobile (6, 7) raccordé audit récepteur, dont il reçoit des données de positions (5) en vue de traiter ces dernières et de les envoyer à une centrale (3), en tant que messages de positions (8), **caractérisé par** un générateur (9) de signaux de test qui est situé dans l'appareil embarqué (1) et peut être sélectivement connecté à l'émetteur-récepteur (6, 7), à la place du récepteur (4) de navigation par satellite, en vue d'entrer des données de test de positions (11) dans ledit émetteur-récepteur (6, 7), ledit générateur (9) de signaux de test pouvant être mis en circuit au cours du fonctionnement sur demande de la centrale (3) décodée par ledit émetteur-récepteur (6, 7), à des instants aléatoires ou à des périodes quotidiennes préétablies, et/ou la mise en circuit dudit générateur (9) de signaux de test étant commandée par une horloge (6) et/ou par un générateur (6) de nombres aléatoires et/ou par un module de chien de garde (6).

2. Appareil embarqué selon la revendication 1, **caractérisé par le fait que** le générateur (9) de signaux de test renferme les données de test de positions (11) dans une mémoire, de manière préétablie.

3. Appareil embarqué selon la revendication 1 ou 2, **caractérisé par le fait que** l'émetteur-récepteur (6, 7) affecte une identification spécifique aux messages de positions (8) fondés sur des données de test de positions (11).

4. Procédé de mesure de l'aptitude fonctionnelle d'un système de péage routier comprenant une centrale (3), un réseau radio mobile (2) et une multiplicité d'appareils embarqués (1) conformes à l'une des revendications 1 à 3, incluant les étapes:
entrée de données de test de positions (11) dans les appareils embarqués (1), au moyen d'un générateur (9) de signaux de test situé dans l'appareil embarqué (1),
réception par lesdits appareils embarqués (1), par l'intermédiaire du réseau radio mobile (2) dans la centrale (3), de messages de positions (8) fondés sur ces données de test de positions (11), et
comparaison des messages de positions reçus (8) avec des messages de positions émulés, dans la centrale (3), sur la base desdites données de test de positions (11),
ledit générateur (9) de signaux de test étant mis en circuit au cours du fonctionnement sur demande de la centrale (3) décodée par ledit émetteur-récepteur (6, 7), à des instants aléatoires ou à des périodes quotidiennes préétablies, et/ou la mise en circuit dudit générateur (9) de signaux de test étant commandée par une horloge (6) et/ou par un générateur (6) de nombres aléatoires et/ou par un module de chien de garde (6).

5. Procédé selon la revendication 4, combiné à des appareils embarqués conformes à la revendication 3, **caractérisé par le fait que** la centrale (3) détecte les messages de positions (8), devant être comparés, sur la base de leur identification.

6. Procédé selon la revendication 4 ou 5, **caractérisé par le fait que** la centrale (3) interprète statistiquement les résultats des comparaisons de la multiplicité d'appareils embarqués (1), de manière à établir une mesure de la performance du système de péage routier (1-3).

7. Procédé selon l'une des revendications 4 à 6, **caractérisé par le fait que** la centrale (3) signalise un message d'erreur en cas d'absence de réception ou lors d'une réception de messages de positions erronés (8) en réaction aux données de test de positions (11).
